# EUROPÄISCHE PATENTANMELDUNG

(11) **EP 3 007 523 A1**
(43) Veröffentlichungstag der Anmeldung: **13.04.2016**
(21) Anmeldenummer: 15187018.5
(22) Anmeldetag: 28.09.2015
(51) Int. Cl.: H05K 1/02, H05K 1/11, G09F 9/33, G09F 9/302

(54) **ANZEIGEVORRICHTUNG**

(30) Priorität: 06.10.2014 DE 102014220188
(71) Anmelder: E.G.O. Elektro-Gerätebau GmbH, 75038 Oberderdingen (DE)
(72) Erfinder: Henrich, Micha, 75031 Eppingen (DE)
(74) Vertreter: Patentanwälte Ruff, Wilhelm, Beier, Dauster & Partner mbB

(57) **Zusammenfassung**

Die Erfindung betrifft eine Anzeigevorrichtung mit einer Leiterplatte und einer Anzahl von Leuchtdioden, wobei auf der Leiterplatte eine strukturierte Kupferbeschichtung vorgesehen ist. Die Kupferbeschichtung weist Abschirmbereiche auf, welche ein Eindringen von Licht, welches von den Leuchtdioden nach unten emittiert wird, in die Leiterplatte hinein verringern oder verhindern. Damit wird ein Austreten von Licht an unerwünschten Stellen wieder aus der Leiterplatte heraus verringert oder verhindert.

## Beschreibung

Die Erfindung betrifft eine Anzeigevorrichtung für ein Haushaltsgerät, insbesondere für ein Kochfeld oder einen Backofen.

Derartige Anzeigevorrichtungen sind aus der DE 102012219040 A1 oder der EP 859467 A1 bekannt. Sie können beispielsweise für diverse Haushaltsgeräte wie Kochfelder, Backöfen oder Mikrowellengeräte verwendet werden. Häufig sind die Leuchtdioden so angeordnet, dass sie zusammen eine Sieben-Segment-Anzeige bilden. Damit eine von der Anzeigevorrichtung über die Leuchtdioden an einen Benutzer vermittelte Information gut abgelesen werden kann und ferner auch eine gewisse Ästhetik erreicht wird ist es von Vorteil, wenn von den Leuchtdioden emittiertes Licht möglichst nur in einer definierten Richtung abgegeben wird. Diese Richtung verläuft häufig rechtwinklig zu einer durch die Leiterplatte definierten Ebene.

Es hat sich jedoch gezeigt, dass Leuchtdioden üblicherweise Licht nicht nur in eine gewünschte Richtung emittieren, sondern insbesondere auch in Richtung zur Leiterplatte hin emittieren, wenn auch mit geringerer Intensität. Üblicherweise verwendete Leiterplatten sind aus einem Material hergestellt, welches lichtleitende Fasern enthält, beispielsweise Glasfasern. Dies kann dazu führen, dass Licht unter einer Leuchtdiode in die Leiterplatte eindringt, in einer solchen lichtleitenden Faser an einen anderen Ort auf der Oberfläche der Leiterplatte gelangt und dort wieder austritt. Dies kann zu unerwünschten und störenden zusätzlichen Lichterscheinungen führen.

Darüber hinaus sorgt lichtstreuendes Material von über den LED angeordneten Leuchtkappen bzw. Lichtkanälen dafür, dass auch ein Teil des nach oben emittierten Lichts wieder nach unten in Richtung der Leiterplatte geleitet wird. Diese Materialeigenschaft der Leuchtkappen bzw. Lichtkanäle schluckt zwar als eine Art Diffusor Lichtanteile, ist jedoch zur besseren Ausleuchtung von darüber angeordneten Symbolen odgl. notwendig.

Der Erfindung liegt die Aufgabe zugrunde, eine eingangs genannte Anzeigevorrichtung zu schaffen, mit der Probleme des Standes der Technik vermieden werden und es insbesondere möglich ist, Streulicht bzw. unerwünschte Lichterscheinungen zu vermeiden.

Gelöst wird diese Aufgabe durch eine Anzeigevorrichtung mit den Merkmalen des Anspruchs 1. Vorteilhafte sowie bevorzugte Ausgestaltungen der Erfindungen sind Gegenstand der weiteren Ansprüche und werden im Folgenden näher erläutert. Der Wortlaut der Ansprüche wird durch ausdrückliche Bezugnahme zum Inhalt der Beschreibung gemacht.

Die Anzeigevorrichtung weist eine Leiterplatte bzw. einen Bauteilträger auf mit einer strukturierten Kupferbeschichtung, vorteilhaft eine übliche Leiterplatte mit Glasfasern, die in ein Harz eingebettet sind, auf der eine übliche Kupferbeschichtung aufgebracht ist, insbesondere auf einer Oberseite. Eine solche Kupferbeschichtung hat bei Leiterplatten gemäß dem Stand der Technik die Funktion, bestimmte Bauteile zu verbinden oder Bereiche der Leiterplatte elektrisch zu erden, insbesondere jeweils mit Leiterbahnen. Auf der Leiterplatte bzw. auf der Kupferbeschichtung ist eine Anzahl von Kontaktfeldern definiert, die insbesondere jeweils mit Leiterbahnen verbunden werden. Diese können zum Anschluss von elektrischen Bauteilen auf der Oberseite verwendet werden.

Die Anzeigevorrichtung weist des Weiteren eine Anzahl von Leuchtdioden als vorgenannte Bauteile auf der Oberseite auf. Jede Leuchtdiode weist einen ersten Anschluss und einen zweiten Anschluss auf. Diese Anschlüsse ermöglichen eine elektrische Kontaktierung der Leuchtdiode zu deren elektrischer Versorgung bzw. Ansteuerung. Die Leuchtdioden sind derart auf der Leiterplatte montiert und elektrisch angeschlossen, dass jeder Anschluss an einem jeweils zugeordneten Kontaktfeld befestigt ist.

Zwischen jeweils zwei Kontaktfeldern, an welchen die zwei Anschlüsse einer einzigen Leuchtdiode befestigt sind, ist eine Zwischenfläche der Leiterplatte ausgebildet, welche von der Leuchtdiode überdeckt wird. Es sei erwähnt, dass insbesondere Licht, welches aus der Leuchtdiode in einer Richtung auf die Leiterplatte zu austritt, in dieser Zwischenfläche grundsätzlich in die Leiterplatte eindringen kann. Das gilt auch für den vorgenannten Effekt, dass Licht von über den LED angeordneten Leuchtkappen bzw. Lichtkanälen zum Teil wieder nach unten in Richtung der Leiterplatte geleitet wird. Dies kann insbesondere der Fall sein, wenn die Leiterplatte lichtleitende Fasern enthält, beispielsweise Glasfasern, die in ein Harz eingebettet sind. Dies ist beispielsweise bei einem häufig verwendeten und typischerweise als FR4 bezeichneten Material der Fall.

Erfindungsgemäß ist vorgesehen, dass die Kupferbeschichtung eine Anzahl von Abschirmbereichen aufweist, welche jeweils eine Zwischenfläche zumindest teilweise bedecken, vorteilhaft also eine Abschirmfläche pro Zwischenfläche bzw. pro Leuchtdiode. Die Abschirmbereiche sind also aus der Kupferbeschichtung heraus geformt bzw. werden von ihr gebildet, vorteilhaft mit derselben Dicke der Kupferbeschichtung auch in den übrigen Bereichen. Mittels der Abschirmbereiche wird Licht daran gehindert, unterhalb der Leuchtdiode bzw. aus deren Unterseite in die Leiterplatte einzudringen, da die Kupferbeschichtung lichtundurchlässig ist. Dies gilt auch für Licht, das außerhalb bzw. neben der LED und evtl. unter einer vorgenannten Leuchtkappe bzw. Lichtkanal nach unten geleitet wird. Da das Licht schon gar nicht in die Leiterplatte eindringt, kann es auch nirgendwo anders aus dieser heraustreten. Sofern die Abschirmbereiche nur dazu geeignet sind, das Eintreten von Licht zu verringern anstatt es vollständig zu verhindern, beispielsweise weil sie nicht die gesamte Fläche unterhalb der Leuchtdiode bedecken, können sie immerhin störende Wirkungen verringern. Des Weiteren kann über die Abschirmbereiche der Kupferbeschichtung möglicherweise auch noch die Ableitung von Verlustwärme von der LED verbessert werden. Durch die zusätzliche niederohmige Anbindung der LED kann ein geringerer Spannungsabfall an den Anschlüssen erreicht werden.

Gemäß einer Ausführung ist jeder Zwischenfläche bzw. jeder Leuchtdiode jeweils genau ein Abschirmbereich zugeordnet. Dies erlaubt eine konsequente Abschirmung des Lichts der Leuchtdioden.

Der Abschirmbereich weist gemäß einer Ausführung einen Abstand zu mindestens einem der Kontaktfelder auf, und zwar vorzugsweise innerhalb der Zwischenfläche bzw. unterhalb der Leuchtdiode. Vorteilhaft weist er einen Abstand zu nur einem der beiden Kontaktfelder auf. Dies führt typischerweise dazu, dass zwischen der Kupferbeschichtung in Form der Abschirmbereiche und den Kontaktfeldern ein jeweiliger nicht leitender Bereich ausgebildet ist, beispielsweise mit einer Breite zwischen 0,1 mm und 1 mm oder sogar 2mm. Damit wird insbesondere ein Kurzschluss bzw. ungewollter elektrischer Kontakt verhindert. Außerdem kann das Vorsehen eines solchen Abstands bzw. nicht leitenden Bereichs für ein Lötverfahren zur Befestigung der Leuchtdioden vorteilhaft sein. Der Abschirmbereich kann von einem Kontaktfeld beabstandet sein und mit dem anderen Kontaktfeld elektrisch verbunden sein, so dass das Potential dieses Kontaktfelds durch den Abschirmbereich definiert wird. Beispielsweise kann eines der beiden Kontaktfelder, an welchem eine einzige Leuchtdiode angeschlossen ist, über den Abschirmbereich und die Kupferbeschichtung geerdet sein. Typischerweise sind alle LED einer Anzeigevorrichtung mit jeweils einem Kontaktfeld, meist der Anode, am selben Potential angeschlossen. Dieses Potential liegt an der Abschirmfläche aus Kupfer. Alle LED sind vorbehaltlich der gewählten geometrischen Ausgestaltung gleichwertig angeschlossen.

Gemäß einer bevorzugten Ausführung sind die Abschirmbereiche zungenartig bzw. als Vorsprünge ausgebildet, wobei vorzugsweise zumindest einige zungenartige Abschirmbereiche ein freies Ende aufweisen. Dies entspricht einer geometrisch einfachen und leicht zu realisierenden Ausführung, in welcher auch einfach ein Abstand zu den Kontaktfeldern erreicht werden kann.

Gemäß einer Ausführung erstrecken sich die Abschirmbereiche entlang einer jeweiligen Längsrichtung, welche quer zu einer Längsrichtung der jeweils darüber angeordneten Leuchtdiode ausgerichtet ist. Vorzugsweise verlaufen die Abschirmbereiche dabei gerade. Dies entspricht ebenfalls einer geometrisch einfach zu realisierenden Ausführung.

Es sei verstanden, dass sich Angaben wie "über", "darüber", "unter" oder "darunter" im Sinne dieser Anmeldung auf eine räumliche Orientierung beziehen, in welcher die Leiterplatte horizontal eben ausgerichtet ist und die Leuchtdioden oben über der Leiterplatte angeordnet sind. Zur Vereinfachung der Beschreibung wird bei solchen Lageangaben typischerweise auf diesen Zustand Bezug genommen, wobei bei einer anderen räumlichen Orientierung die jeweils korrespondierenden Lageangaben einfach identifizierbar sind.

Die Kupferbeschichtung weist bevorzugt zumindest einen außerhalb der Zwischenflächen angeordneten flächigen Bereich auf. Die Abschirmbereiche sind dabei mit jeweils zumindest einem flächigen Bereich elektrisch verbunden. Derartige flächige Bereiche können beispielsweise zu einer großflächigen Bedeckung der Leiterplatte verwendet werden. Damit kann beispielsweise ein Austritt von Licht aus der Leiterplatte verhindert werden. Außerdem kann die Leiterplatte durch diese flächigen Bereiche auf Masse oder ein anderes definiertes elektrisches Potential gelegt werden.

Die Abschirmbereiche sind bevorzugt einseitig oder zweiseitig mit zumindest einem flächigen Bereich bzw. dem größten Teil der Kupferbeschichtung elektrisch verbunden. Damit kann ein Potentialausgleich zwischen flächigen Bereichen und Abschirmbereichen erreicht werden. Die Abschirmbereiche können dabei insbesondere einstückig mit jeweils zumindest einem flächigen Bereich ausgebildet sein. Dies erleichtert ein einfaches Leiterplattendesign und eine einfache Herstellung.

Gemäß einer bevorzugten Ausführung sind die Abschirmbereiche als Auswölbungen oder Vorsprünge aus jeweils zumindest einem flächigen Bereich ausgebildet. Dies erlaubt einen unmittelbaren Anschluss der Abschirmbereiche an jeweils einen flächigen Bereich.

Vorteilhaft ist ein Abschirmbereich vorbehaltlich von Aussparungen mindestens so groß wie das Innenmaß einer vorgenannten Leuchtkappe bzw. einem Lichtkanal, die darüber angeordnet sein können. Nach Möglichkeit sind die Abschirmbereiche größer, damit dennoch eingefallenes Licht gar nicht mehr oder nur noch verteilt und somit schwächer wieder aus der Leiterplatte austreten kann.

Es sei erwähnt, dass Kupferbeschichtungen ohnehin häufig auf Leiterplatten zu finden sind und entsprechende Produktionsschritte ohnehin im Rahmen einer Leiterplattenproduktion ausgeführt werden müssen. Dementsprechend erzeugt das Vorsehen der erfindungsgemäßen Abschirmbereiche einer Kupferbeschichtung im Regelfall nur vernachlässigbare oder keine zusätzliche Kosten.

Die Abschirmbereiche sind bevorzugt von den jeweiligen darüber angeordneten Leuchtdioden beabstandet, beispielsweise mit einem Abstand von 0,1 mm bis 1 mm.

Die Kupferbeschichtung ist bevorzugt geerdet oder elektrisch mit einer ein definiertes elektrisches Potential liefernden Einrichtung verbunden, vorzugsweise zumindest an den Abschirmbereichen. Dies vermeidet Bereiche mit undefiniertem Potential, welche sich eventuell elektrisch aufladen können und damit die Funktion der Leiterplatte stören können.

Die Leuchtdioden sind bevorzugt gemäß Surface-Mounted-Device (SMD) - Technologie ausgebildet und damit auf der Leiterplatte montiert. Dies erlaubt ein einfaches und kostengünstiges Herstellungsverfahren.

Die Abschirmbereiche sind bevorzugt dazu ausgebildet, ein Eindringen von Licht, welches von den Leuchtdioden zur Leiterplatte hin emittiert wird, in die Leiterplatte hinein zu verringern oder zu verhindern. Damit werden die eingangs beschriebenen unerwünschten optischen Effekte vermieden oder verhindert.

Die Abschirmbereiche sind bevorzugt elektrisch unfunktional ausgebildet, selbst wenn sie mit Masse oder High Level verbunden sind. Unter einer elektrisch unfunktionalen Ausbildung sein insbesondere verstanden, dass sie nicht für Zwecke der elektrischen Versorgung einer Leuchtdiode oder eines anderen elektrischen Verbrauches verwendet werden. Sie sind also nicht wegen einer elektrischen Funktion vorhanden bzw. so ausgebildet, sondern nur aus dem Kupfer weil es lichtundurchlässig ist. Dies ermöglicht eine exakte Anpassung der Abschirmbereiche auf deren hier angedachte Funktion, welche im Verringern oder Verhindern des Eindringens von Licht besteht.

Gemäß einer Ausführung ist über jeder Leuchtdiode eine Anzeigekappe oder vorgenannte Leuchtkappe angeordnet, welche einen Lichtkanal für von der Leuchtdiode emittiertes Licht bildet oder anschließt. Oben kann dann die Symbolik leuchtend erzeugt werden. Dies erlaubt eine definierte Leitung von Licht an eine gewünschte Position, an welcher das Licht für einen Benutzer sichtbar sein soll. Es erlaubt außerdem eine Abschirmung von Lichtausbreitung quer zu einer gewünschten Lichtausbreitungsrichtung.

Gemäß einer Ausführung weist die Anzeigevorrichtung eine Anzahl von Sieben-Segment-Anzeigen auf, wobei jede Sieben-Segment-Anzeige sieben Leuchtdioden aufweist. Dies entspricht einer besonders geeigneten Anzeigeform für das Anzeigen von Zahlen. Eine zusätzliche achte Leuchtdiode kann einen Punkt daran beleuchten. An einer solchen Anzeige können natürlich noch mehr Leuchtdioden vorgesehen sein für einzelne Symbole odgl..

Die Erfindung kann grundsätzlich bei allen Anzeigevorrichtungen eingesetzt werden, die Leuchtdioden und Lichtkanäle bzw. Leuchtkappen aufweisen. Der Einsatz ist abhängig vom möglichen Leiterplattendesign. Bevorzugt werden Leiterplattendesigns, die große Abschirmbereiche zulassen. Vorteilhaft können viele oder evtl. sogar alle Leuchtdioden einer Anzeigevorrichtung jeweils einen Anschluss auf demselben Potential haben, so dass dieses Potential über die Abschirmfläche verteilt bzw. angeschlossen werden kann.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in Zwischen-Überschriften und einzelne Abschnitte beschränkt die unter diesen gemachten Aussagen nicht in ihrer Allgemeingültigkeit.

### KURZBESCHREIBUNG DER ZEICHNUNGEN

Weitere Vorteile und Aspekte der Erfindung ergeben sich aus den Ansprüchen und aus der nachfolgenden Beschreibung eines bevorzugten Ausführungsbeispiels der Erfindung, das nachfolgend anhand der Figuren erläutert ist. Dabei zeigen:
- Fig. 1: eine Leiterplatte für eine Anzeigevorrichtung,
- Fig. 2: die Leiterplatte aus Fig. 1 in Vergrößerung,
- Fig. 3: die Leiterplatte aus Fig. 2 mit bestückten LED und
- Fig. 4: die Anzeigevorrichtung von Fig. 3 in einer Schnittansicht.

### DETAILLIERTE BESCHREIBUNG DES AUSFÜHRUNGSBEISPIELS

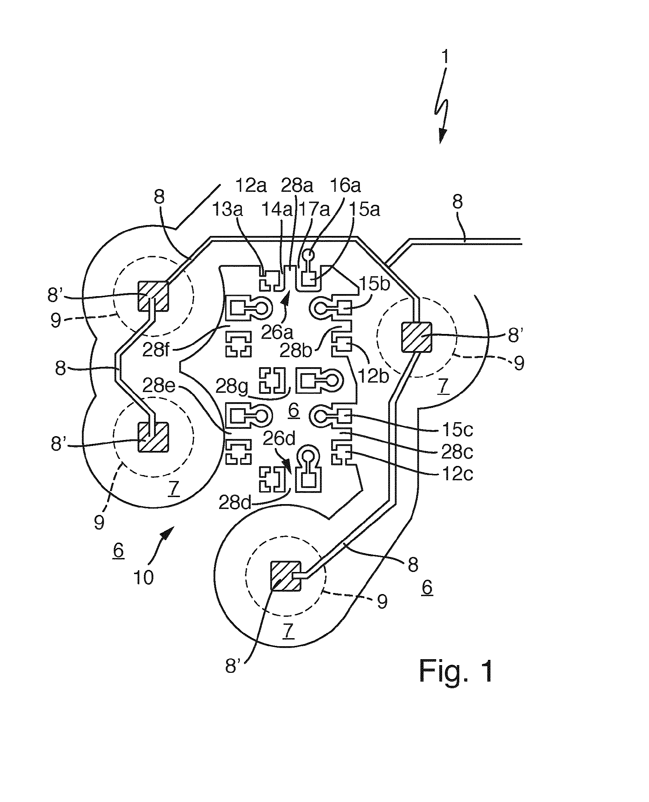

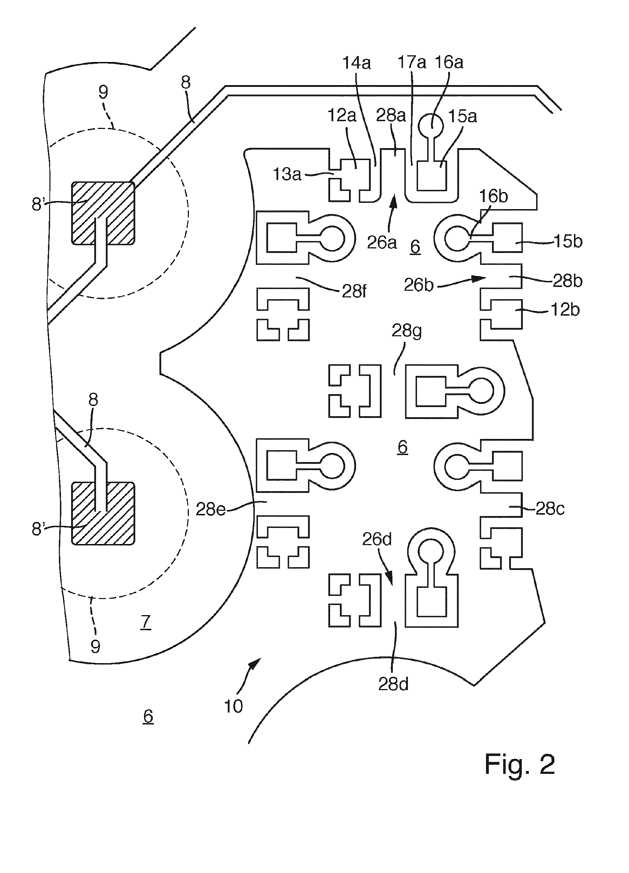

Fig. 1 zeigt schematisch und die Fig. 2 einen zentralen Ausschnitt in Vergrößerung einer Anzeigevorrichtung 1, wie sie in einem Kochfeld unter einer Bedienoberfläche, insbesondere der Kochfeldplatte aus Glaskeramik, angeordnet sein kann. Die Anzeigevorrichtung 1 weist eine Leiterplatte 5 auf, welche vorliegend aus einem Glasfasern enthaltenden Material ausgebildet ist. Die Leiterplatte weist eine obere Kupferbeschichtung 6 auf und eine nicht dargestellte untere Kupferbeschichtung, wie dies bekannt ist. Auf der Leiterplatte 5 ist eine Sieben-Segment-Anzeige 10 angeordnet. Zu deren elektrischem Anschluss sind aus der oberen Kupferbeschichtung 6 und ggf. auch aus der unteren Kupferbeschichtung Strukturen bzw. freie Bereiche 7 herausgearbeitet, und zwar üblicherweise geätzt.

Außerdem sind auf der Leiterplatte 5 der Anzeigevorrichtung 1 noch für eine kombinierte Bedieneinrichtung Berührungsschalter vorgesehen. Dazu sind relativ dünne Sensor-Leiterbahnen 8a vorgesehen, die an Sensor-Kontaktfelder 8' gehen. An diesen sind hier wiederum gestrichelt dargestellte Sensorelemente 9 angebracht, wobei nur über die Anlage oder über einen Leitkleber die elektrische Verbindung hergestellt wird. Die Sensorelemente 9 können größer oder auch kleiner sein als die Sensor-Kontaktfelder 8'. Diese Herstellung der elektrischen Verbindung ist bekannt aus der EP 859467 A1, auf die diesbezüglich explizit verwiesen wird. Alternativ können anders ausgebildete elektrisch leitfähige Sensorelemente aus elastischem Material vorgesehen sein, insbesondere auch in zusammenhängenden Strukturen.

Die Sieben-Segment-Anzeige 10 soll eben sieben LED aufweisen bzw. Anschlussmöglichkeiten für diese. Diese werden auf bekannte Art und Weise gebildet durch in etwa rechteckige bzw. quadratische Felder der Kupferbeschichtung 6, nämlich erste Kontaktfelder 12a-g und zweite Kontaktfelder 15a-g. Die ersten Kontaktfelder 12a-g sind sämtlich an die obere Kupferbeschichtung elektrisch angeschlossen, und zwar über Kontaktbrücken 13a-g, die jeweils den die ersten Kontaktfelder 12a-g von der restlichen Kupferfläche trennenden Graben 14a-g überbrücken. Deutlich erkennbar können pro erstem Kontaktfeld eine bis drei Kontaktbrücken 13a-g vorgesehen sein, abhängig von den geometrischen Verhältnissen und dem Platz.

Die zweiten Kontaktfelder 15a-g sind ebenfalls über Gräben 17a-g von der restlichen Kupferbeschichtung 6 getrennt, die teilweise aber eine andere Form aufweisen. Die zweiten Kontaktfelder 15a-g weisen Kontaktbrücken 16a-g auf, die anders ausgebildet sind. Sie laufen ein kurzes Stück auf der Leiterplatte 5 und sind dann aber auf deren Unterseite durchkontaktiert, üblicherweise mittels einer Durchbohrung, die als Durchkontaktierung ausgekupfert und/oder entsprechend der Oberfläche der Kontaktfelder verzinnt sein kann. Deswegen sind die Gräben 17a-g auch etwas anders ausgebildet. Dabei sind die Gräben 14a-g und 17a-g dazu vorgesehen, die elektrischen Potentiale zu trennen. Um zu verhindern, dass beim SMD-Löten Lötzinn auf benachbarte Kupferflächen ausfließt, wird typischerweise Lötstopplack verwendet.

Zwischen den Kontaktfeldern 12a-g und 15a-g sind Zwischenflächen 26a-g vorgesehen. Erfindungsgemäß ist nun die obere Kupferbeschichtung 6 hier so weit wie aus elektrischen Gründen möglich als vorgenannter Abschirmbereich 28a-g zwischen die beiden Kontaktfelder bzw. unter die später aufgebrachte LED gezogen. Zu den Kontaktfeldern 12a-g und 15a-g müssen die Abschirmbereiche 28d-g einen Abstand entsprechend den Gräben 14a-g und 17a-g aufweisen, sonst gibt es die vorgenannten Probleme beim SMD-Löten. Die Abschirmbereiche 28d-g sind ganz durchgängig und gehen an beiden Enden in die Kupferbeschichtung über. Sie liegen damit auf deren Potential, meistens auf High Level, unter Umständen auf Masse, was aber nicht stört. Vor allem aber schirmen sie so die Oberfläche der Leiterplatte 5 gegen unerwünschten Lichteintritt von oben durch die LED ab. Normalerweise wäre hier in den Zwischenbereichen die Kupferbeschichtung 5 ebenfalls entfernt und die Oberfläche der Leiterplatte läge frei, so dass Licht unerwünscht eingekoppelt werden kann wie eingangs erläutert mit ebenjenen negativen Folgen.

Die Abschirmbereiche 28a-c sind dagegen als längliche Zungen mit freien Enden ausgebildet. Sie können nicht länger sein wegen des geringen Abstands zu den Sensor-Leiterbahnen 8a bzw. den Sensorelementen 9 selbst. Diese brauchen zur Vermeidung von Störungseinkopplungen besonders viel Abstand zu anderen Signalleitungen oder Masse. Der zungenförmige Abschirmbereich 28b ist sogar noch kürzer als die anderen beiden, er geht nicht einmal über die gesamte Breite, die nachher von der LED überdeckt wird. Das liegt am notwendigen Abstand zum Sensorelement 9, der eben zwingend ist und gegenüber dem die mögliche Lichteinkopplung dieser LED in die Leiterplatte 5 zurückstehen muss. Deswegen geht der Abschirmbereich 28b sogar nur über etwas mehr als die halbe Breite der LED.

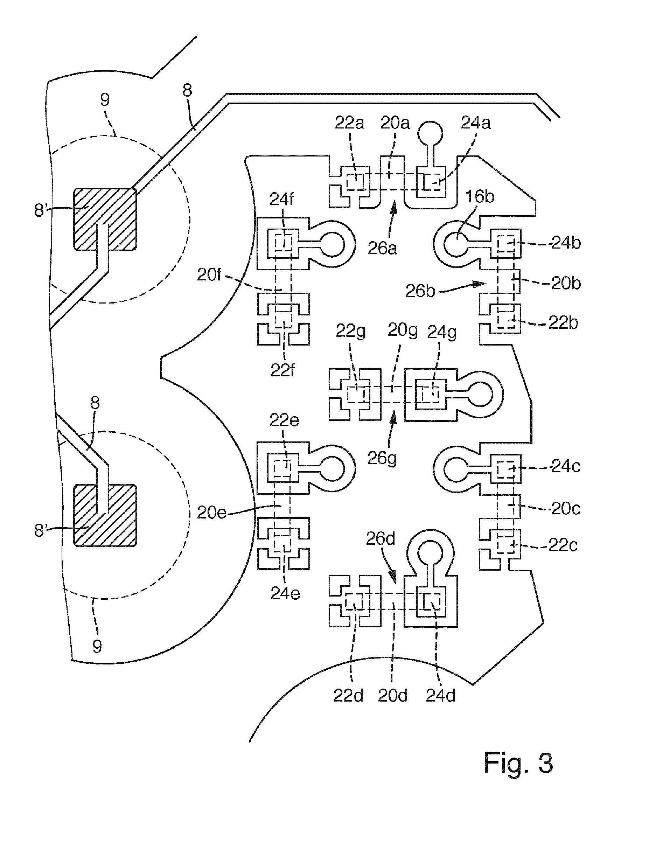

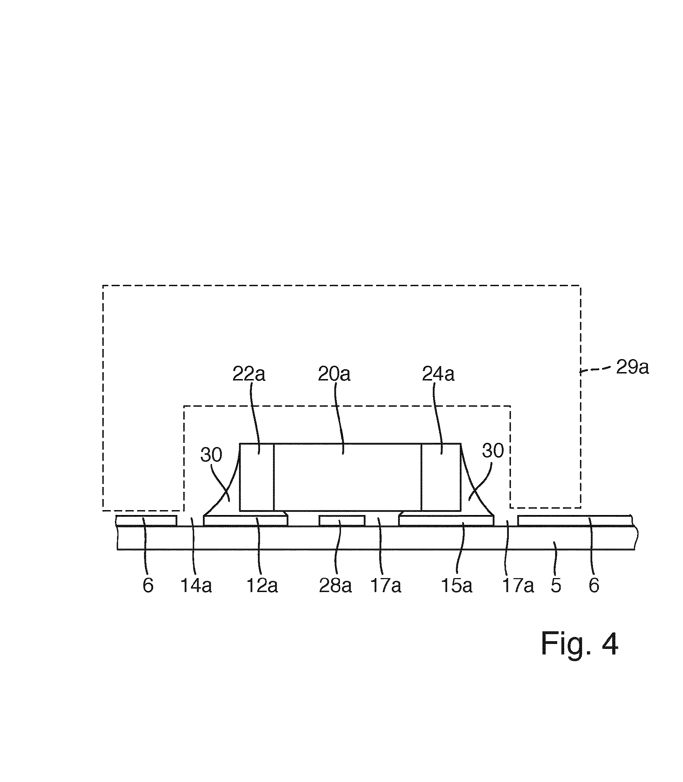

In der Fig. 3 sind nun im Vergleich zur Fig. 2 die LED 20a-g gestrichelt dargestellt. Die strichlierte Darstellung dient der Übersichtlichkeit. Die LED 20a-g sind als völlig übliche SMD-LED ausgebildet und weisen an den Enden jeweils Anschlüsse 22a-g und 24a-g auf. Mit diesen Anschlüssen 22a-g und 24a-g sind sie auf den Kontaktfeldern 12a-g und 15a-g aufgelötet in einem üblichen SMD-Verfahren mit Lötzinn 30. Dies zeigt die Fig. 4 im seitlichen Schnitt für die LED 20a. Dort sind auch die Gräben 14a und 17a zu erkennen, die um die Kontaktfelder 12a und 15a verlaufen. Die Kontaktbrücken 13a und 16a sind hier nicht dargestellt.

Die LED 20a kann auf dem Abschirmbereich 28a aufliegen, was elektrisch nicht stört. So könnte sie sogar Abwärme besser abtransportieren.

Über der LED 20a ist eine Anzeigekappe 29a gestrichelt dargestellt als vorgenannte Leuchtkappe. Diese kann das Licht der LED 20a vergleichmäßigen und ggf. noch mit einer Symboldarstellung versehen. Ebenso kann sie einen seitlichen Lichtaustritt aus der LED 20a verhindern, der zu unerwünschten Leuchteffekten führen würde, die von oben sichtbar wären. Diese Anzeigekappe 29a kann beispielsweise gemäß der DE 102009024642 A1 ausgebildet sein.

## Patentansprüche

1. Anzeigevorrichtung (1), aufweisend:
- eine Leiterplatte (5) mit einer strukturierten Kupferbeschichtung (6), auf welcher eine Anzahl von Kontaktfeldern (12a-g, 14a-g) definiert ist, und
- eine Anzahl von Leuchtdioden (20a-g) mit jeweils einem ersten Anschluss (22a-g) und einem zweiten Anschluss (24a-g),
- wobei die Leuchtdioden (20a-g) derart auf der Leiterplatte (5) montiert und elektrisch angeschlossen sind, dass jeder Anschluss (22a-g, 24a-g) an einem jeweils zugeordneten Kontaktfeld (12a-g, 14a-g) befestigt ist,
- wobei zwischen jeweils zwei Kontaktfeldern (12a-g, 14a-g), an welchen die zwei Anschlüsse (22a-g, 24a-g) einer einzigen Leuchtdiode (20a-g) befestigt sind, eine Zwischenfläche (26a-g) der Leiterplatte (5) ausgebildet ist, welche von der Leuchtdiode (20a-g) überdeckt wird,
**dadurch gekennzeichnet, dass** die Kupferbeschichtung (6) eine Anzahl von Abschirmbereichen (28a-g) aufweist, welche jeweils eine Zwischenfläche (26a-g) zumindest teilweise bedecken.

2. Anzeigevorrichtung (1) nach Anspruch 1, **dadurch gekennzeichnet, dass** jeder Zwischenfläche (26a-g) jeweils genau ein Abschirmbereich (28a-g) zugeordnet ist.

3. Anzeigevorrichtung (1) nach Anspruch 1 oder 2, **dadurch gekennzeichnet, dass** die Kupferbeschichtung (6) von den Kontaktfeldern (12a-g, 14a-g) beabstandet ist, vorzugsweise innerhalb der Zwischenfläche (26a-g) bzw. unterhalb der Leuchtdiode (20a-g).

4. Anzeigevorrichtung (1) nach einem der vorhergehenden Ansprüche, **dadurch gekennzeichnet, dass** die Abschirmbereiche (28a-g) zungenartig bzw. als Vorsprünge ausgebildet sind, wobei vorzugsweise zumindest einige zungenartige Abschirmbereiche (28a-g) ein freies Ende aufweisen.

5. Anzeigevorrichtung (1) nach einem der vorhergehenden Ansprüche, **dadurch gekennzeichnet, dass** sich die Abschirmbereiche (28a-g) entlang einer jeweiligen Längsrichtung erstrecken, welche quer zu einer Längsrichtung der jeweiligen darüber angeordneten Leuchtdiode (20a-g) ausgerichtet ist, wobei vorzugsweise die Abschirmbereiche (28a-g) gerade verlaufen.

6. Anzeigevorrichtung (1) nach einem der vorhergehenden Ansprüche, **dadurch gekennzeichnet, dass** die Kupferbeschichtung (6) zumindest einen außerhalb der Zwischenflächen (26a-g) angeordneten flächigen Bereich aufweist, wobei die Abschirmbereiche (28a-g) mit jeweils zumindest einem flächigen Bereich elektrisch verbunden sind, wobei vorzugsweise die Abschirmbereiche (28a-g) einseitig oder zweiseitig mit zumindest einem flächigen Bereich der Kupferbeschichtung (6) elektrisch verbunden sind.

7. Anzeigevorrichtung (1) nach Anspruch 6, **dadurch gekennzeichnet, dass** die Abschirmbereiche (28a-g) einstückig mit jeweils zumindest einem flächigen Bereich ausgebildet sind.

8. Anzeigevorrichtung (1) nach Anspruch 6 oder 7, **dadurch gekennzeichnet, dass** die Abschirmbereiche (28a-g) als Auswölbungen oder Vorsprünge aus jeweils zumindest einem flächigen Bereich (30) ausgebildet sind.

9. Anzeigevorrichtung (1) nach einem der vorhergehenden Ansprüche, **dadurch gekennzeichnet, dass** die Abschirmbereiche (28a-g) von den jeweiligen darüber angeordneten Leuchtdioden (20a-g) beabstandet sind.

10. Anzeigevorrichtung (1) nach einem der vorhergehenden Ansprüche, **dadurch gekennzeichnet, dass** die Kupferbeschichtung (6) geerdet ist oder elektrisch mit einer ein definiertes elektrisches Potential liefernden Einrichtung verbunden ist, vorzugsweise zumindest an den Abschirmbereichen (28a-g).

11. Anzeigevorrichtung (1) nach einem der vorhergehenden Ansprüche, **dadurch gekennzeichnet, dass** die Leuchtdioden (20a-g) mittels Surface Mounted Device (SMD) - Technologie auf der Leiterplatte (5) montiert sind.

12. Anzeigevorrichtung (1) nach einem der vorhergehenden Ansprüche, **dadurch gekennzeichnet, dass** die Abschirmbereiche (28a-g) dazu ausgebildet sind, ein Eindringen von Licht, welches von den Leuchtdioden (20a-g) zur Leiterplatte (5) hin emittiert wird, in die Leiterplatte (5) hinein zu verringern oder zu verhindern.

13. Anzeigevorrichtung (1) nach einem der vorhergehenden Ansprüche, **dadurch gekennzeichnet, dass** die Abschirmbereiche (28a-g) elektrisch unfunktional ausgebildet sind.

14. Anzeigevorrichtung (1) nach einem der vorhergehenden Ansprüche, **dadurch gekennzeichnet, dass** über jeder Leuchtdiode (20a-g) eine Anzeigekappe (29a) angeordnet ist, welche einen Lichtkanal für von der Leuchtdiode (20a-g) emittiertes Licht bildet oder anschließt.

15. Anzeigevorrichtung (1) nach einem der vorhergehenden Ansprüche, **dadurch gekennzeichnet, dass** die Anzeigevorrichtung (1) eine Anzahl von Sieben-Segment-Anzeigen (10) aufweist, wobei jede Sieben-Segment-Anzeige (10) sieben Leuchtdioden (20a-g) aufweist.
